(19) Europäisches Patentamt
European Patent Office
Office européen des brevets

(11) **EP 3 443 677 B1**

(12) **EUROPEAN PATENT SPECIFICATION**

(45) Date of publication and mention
of the grant of the patent:
**20.04.2022 Bulletin 2022/16**

(21) Application number: **16757845.9**

(22) Date of filing: **18.08.2016**

(51) International Patent Classification (IPC):
**H03M 13/13** $^{(2006.01)}$    **H03M 13/00** $^{(2006.01)}$

(52) Cooperative Patent Classification (CPC):
**H03M 13/13; H03M 13/618; H03M 13/6362**

(86) International application number:
**PCT/EP2016/069593**

(87) International publication number:
**WO 2018/033206 (22.02.2018 Gazette 2018/08)**

(54) **COMMUNICATION DEVICE AND COMMUNICATION METHOD USING POLAR CODES**

KOMMUNIKATIONSVORRICHTUNG UND VERFAHREN UNTER VERWENDUNG VON POLAR CODES

APPAREIL ET MÉTHODE CE COMMUNICATION UTILISANT DES CODES POLAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.02.2019 Bulletin 2019/08**

(73) Proprietor: **Huawei Technologies Co., Ltd.**
**Longgang District**
**Shenzhen, Guangdong 518129 (CN)**

(72) Inventors:
• **GABRY, Frederic**
**80992 Munich (DE)**
• **BIOGLIO, Valerio**
**80992 Munich (DE)**
• **BELFIORE, Jean-Claude**
**80992 Munich (DE)**
• **LAND, Ingmar**
**80992 Munich (DE)**

(74) Representative: **Pfenning, Meinig & Partner mbB**
**Patent- und Rechtsanwälte**
**Joachimsthaler Straße 10-12**
**10719 Berlin (DE)**

(56) References cited:
**US-B1- 8 347 186**

• **MAHDAVIFAR HESSAM ET AL: "Polar Coding for Bit-Interleaved Coded Modulation", IEEE TRANSACTIONS ON VEHICULAR TECHNOLOGY, IEEE SERVICE CENTER, PISCATAWAY, NJ, US, vol. 65, no. 5, May 2016 (2016-05), pages 3115-3127, XP011609968, ISSN: 0018-9545, DOI: 10.1109/TVT.2015.2443772 [retrieved on 2016-05-12]**
• **TRIFONOV PETER ET AL: "Fast Encoding of Polar Codes With Reed-Solomon Kernel", IEEE TRANSACTIONS ON COMMUNICATIONS, IEEE SERVICE CENTER, PISCATAWAY, NJ. USA, vol. 64, no. 7, July 2016 (2016-07), pages 2746-2753, XP011616646, ISSN: 0090-6778, DOI: 10.1109/TCOMM.2016.2576448 [retrieved on 2016-07-13]**
• **HUAWEI ET AL: "Overview of Polar Codes", 3GPP DRAFT; R1-162161, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Busan, Korea; 20160411 - 20160415 2 April 2016 (2016-04-02), XP051080007, Retrieved from the Internet: URL:http://www.3gpp.org/ftp/tsg_ran/WG1_RL 1/TSGR1_84b/Docs/ [retrieved on 2016-04-02]**

EP 3 443 677 B1

- EROZ M ET AL: "On the design of prunable interleavers for turbo codes", VEHICULAR TECHNOLOGY CONFERENCE, 1999 IEEE 49TH HOUSTON, TX, USA 16-20 MAY 1999, PISCATAWAY, NJ, USA,IEEE, US, vol. 2, 16 May 1999 (1999-05-16), pages 1669-1673, XP010342111, DOI: 10.1109/VETEC.1999.780687 ISBN: 978-0-7803-5565-1
- MYUNG-KYU LEE ET AL: "The Exponent of a Polarizing Matrix Constructed from the Kronecker Product", ARXIV.ORG, CORNELL UNIVERSITY LIBRARY, 201 OLIN LIBRARY CORNELL UNIVERSITY ITHACA, NY 14853, 17 August 2011 (2011-08-17), XP080521338, DOI: 10.1007/S10623-012-9689-Z

**Description**

TECHNICAL FIELD

The invention relates to communication devices and methods, especially the channel coding aspect thereof.

BACKGROUND

Polar codes are a new class of channel codes. They are provably capacity-achieving over various classes of channels, and they provide excellent error rate performance for practical code lengths.

In their original construction, polar codes are based on the polarization effect of the Kronecker products of the matrix

$$T_2 = \begin{pmatrix} 1 & 0 \\ 1 & 1 \end{pmatrix}$$

This matrix is called *Kernel* of the polar code. The generator matrix of a polar code is a sub-matrix of $T_2^{\otimes n}$ formed by rows of $T_2^{\otimes n}$. As a consequence, only code lengths of the form $N = 2^n$ can be generated. On the other hand, any code dimension - the number of information bits - $K$ is possible. Thus polar codes admit any code rate.

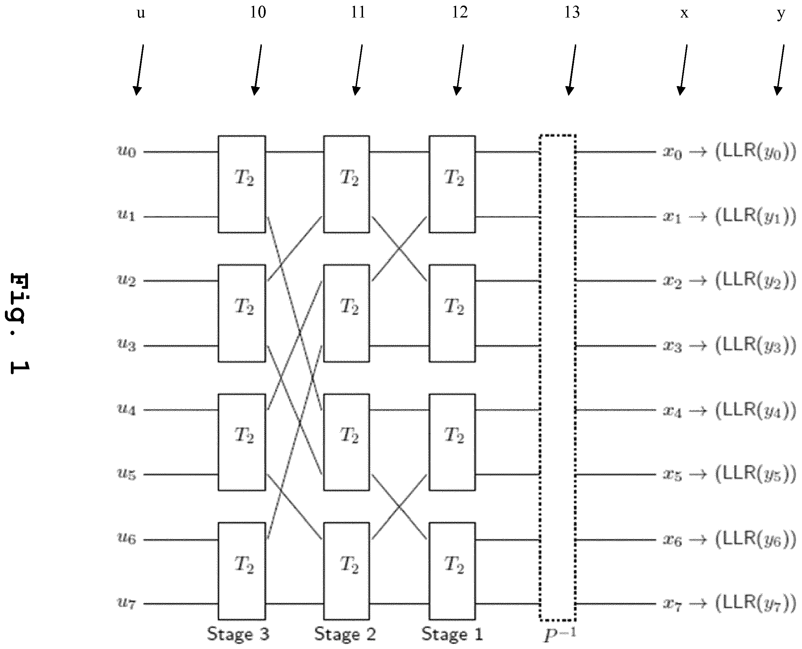

A codeword $x$ of length $N = 2^n$ is obtained as $x = u \cdot T_2^{\otimes n}$, where $u$ is the input vector of length $N$, and $T_2^{\otimes n}$ the transformation matrix of the polar code, with $n = \log_2 N$. An illustration of the encoding for a 8-bit polar code is given in Fig. 1.

On a first level, a number of Kernels 10 modifies the input symbols u. On a second level, a number of Kernels 11 modifies the already modified input symbols u. Finally, on a third level, a number of Kernels 11 modifies the already twice modified input symbols u resulting in a number of output symbols x. The output symbols x are though not in the same order as the input symbols u. Therefore a bit-reversal permutation unit 13 is inserted. This allows for a display of the output symbols x in the same order as the input symbols u.

The main idea of polar codes is that, based on this encoding procedure and for example, successive-cancellation decoding, as explained below, some input bit positions will be more reliable than others. This is called the polarization phenomenon. The information bits are put in the most reliable positions of u, while the unreliable positions are fixed to the bit value 0, called frozen bits. The set of frozen bit positions is called the frozen set. The reliability of input bit positions can be obtained by density evolution, genie-aided simulation, or other similar methods.

Continuing the example from Fig. 1, the bits ordered by decreasing reliability are $[u_8, u_7, u_6, u_4, u_5, u_3, u_2, u_1]$. If the coding rate is fixed to R = ½, which means $K = 4$ information bits, the information is put in the 4 most reliable bit positions $[u_8, u_7, u_6, u_4]$, while the 4 less reliable bits are fixed to 0, i.e., they are *frozen.*

The decoding of polar codes is done e.g. using a Successive Cancellation (SC) decoder, as depicted in the rightmost part of Fig. 1, where a log likelihood ratio (LLR) of a number of received symbols y is shown for the 8-bit polar code. In the SC decoder, input bits on the left side of the graph are decoded successively from top to bottom by propagating the LLR values from right to left and hard-decisions from left to right. The LLRs $L_0^{(0)}, ... , L_0^{(7)}$ appearing at the right side correspond to the channel observation, which correspond to the received symbols y. We note that the code of length N=8 has $s = \log_2 8 = 3$ stages. In Fig. 1, the stages are numbered in decoding direction, while before levels are mentioned, which are inversely numbered. At each stage there are 4 $T_2$ nodes, referred to as $T_2$ boxes in the following, of size 2-by-2. LLRs and hard-decisions are computed according to update functions.

It was conjectured that the polarization phenomenon is not restricted to the proposed Kernel of dimension 2. This conjecture has been proven, where necessary and sufficient conditions are presented for Kernels $T_l$ of any dimension $l > 2$ to permit the polarization effect. This allowed the proposition of polar codes based on larger Kernels, both linear and non-linear. In this way, a polar code of any block length of the form $N = l^n$ can be generated.

However, many block lengths cannot be expressed in the form $N = l^n$. To overcome this limitation, puncturing and shortening techniques are proposed.

As shown before, a major drawback of polar codes with the Kernel $T_2$ is that the code lengths of the original construction are restricted to powers of 2, i.e., $N = 2^n$. Generalized Kernels allow one to extend the original code length to any power $N = l^n$ with $l \leq 25$. However, this is not sufficient to cover the diversity of block lengths demanded by modern communication systems.

Using puncturing or shortening techniques from coding theory, the codes can be trimmed to any code length. Puncturing and shortening are proposed for the original polar codes of length $N = 2^n$.

Puncturing has the benefit of making the code rate more flexible and allows immediately for incremental redundancy. On the downside, puncturing makes it hard to control the code properties, in particular the minimum distance and thus the error correction capability. If a codeword of code length N' has to be created to encode K information bits, a mother (N,K) polar code is used to encode the data, with N > N', and N-N' bits are punctured, i.e., not transmitted.

Shortening achieves the same code rate flexibility as puncturing, however without degrading the error correction performance. If a codeword of code length N' has to be created to encode K information bits, the data is initially padded with S=N-N' zeros, and a (N,K+S) mother polar code is chosen with N > N'. The obtained K+S information bits are encoded using the mother polar encoder such that S encoded bits are equal to zero. Before transmission, the S padding bits are removed. Note that this procedure keeps the minimum distance of the mother polar code and thus provides more control over the code properties than puncturing.

Both shortening and puncturing techniques provide a practical way to construct polar codes of arbitrary lengths based on $N = 2^n$ polar codes (mother polar codes), however with two disadvantages. First, punctured and shortened codes are decoded on the graph of their mother codes, and therefore the decoding complexity is as high as that for the mother code. For strongly punctured or shortened codes, this complexity is very high compared to the code length. Second, puncturing and shortening leads to loss in the code structure and thus to loss in terms of the degree of polarization; this again means degradation in terms of error rate performance.

Therefore, the above described solutions suffer from a strong limitation regarding the possible block lengths of the channel encoding or, in case of the use of puncturing or shortening, other disadvantageous side effects.

Mahdavifar Hessam et al: "Polar Coding for Bit-Interleaved Coded Modulation", IEEE Transactions on Vehicular Technology, vol. 65, no.5 discloses a polar coding scheme or BICM modelled as comprising multiple channels. Compound polar codes of length $N = l2^n$ is constructed by taking an $l \times l$ building block and applying n levels of regular $2 \times 2$ polarization levels on top of the $l \times l$ building block. In an example, a polar code of length $N=3 \times 2^9$ is obtained by combining kernels of size 2 and 3.

Trifonov Peter et al.: "Fast Encoding of Polar Codes With Reed-Solomon Kernel", IEEE Transactions on Communications, vol. 64, no.7, July 2016 discloses a polar coding scheme based on Reed-Solomon Kernels based on a polarization matrix B, wherein the matrix B is an $l \times l$ matrix.

Huawei: "Overview of Polar Codes", 3GPP draft; R1-162161, RAN WG1, Busan, Korea discloses if a codeword of code length N has to be created to encode K information bits, a mother (N', K) polar code is used to encode the data, with N'>N, and N'-N bits are punctured.

Myung-Kyu Lee et al: "The Exponent of a Polarizing Matrix Constructed from the Kronecker Product", ARXIV.ORG, August 2011 discloses a partial distance and the exponent of a polarizing matrix constructed from the Kronecker product. A larger polarizing matrix of size 6 x 6 is constructed based on two kernels with dimensions 2 and 3.

SUMMARY

Accordingly, an object of the present invention is to provide a communication device and communication method, which allow for a high encoding flexibility without suffering any disadvantageous side effects.

The object is solved by the features of claim 1 for the apparatus and claim 10 for the method. Further it is solved by the features of claim 11 for the associated computer program. The dependent claims contain further developments.

According to a first aspect of the invention, a communication device according to claim 1 is provided.

It is thereby possible to use easily available polar code Kernels. By using different polar code Kernels, it is possible to achieve a greater flexibility with regard to the code length N. Using such Kernels also does not incur any other negative side effects.

Generally, it has to be noted that all arrangements, devices, elements, units and means and so forth described in the present application could be implemented by software or hardware elements or any kind of combination thereof. Furthermore, the devices may be processors or may comprise processors, wherein the functions of the elements, units and means described in the present applications may be implemented in one or more processors. All steps which are performed by the various entities described in the present application as well as the functionality described to be performed by the various entities are intended to mean that the respective entity is adapted to or configured to perform the respective steps and functionalities. Even if in the following description or specific embodiments, a specific functionality or step to be performed by a general entity is not reflected in the description of a specific detailed element of that entity which performs that specific step or functionality, it should be clear for a skilled person that these methods and functionalities can be implemented in respect of software or hardware elements, or any kind of combination thereof.

BRIEF DESCRIPTION OF DRAWINGS

The present invention is in the following explained in detail in relation to embodiments of the invention in reference to the enclosed drawings, in which

Fig. 1    shows a first encoding graph;
Fig. 2    shows a second encoding graph;
Fig. 3    shows a first decoding graph;
Fig. 4    shows an embodiment of the inventive communication device according to the first aspect of the invention;
Fig. 5    shows an embodiment of the inventive communication method according to the second aspect of the invention;
Fig. 6    shows first results when using a communication device according to the first aspect of the invention or a communication method according to the second aspect of the invention, and
Fig. 7    shows second results when using a communication device according to the first aspect of the invention or a communication method according to the second aspect of the invention.

DESCRIPTION OF EMBODIMENTS

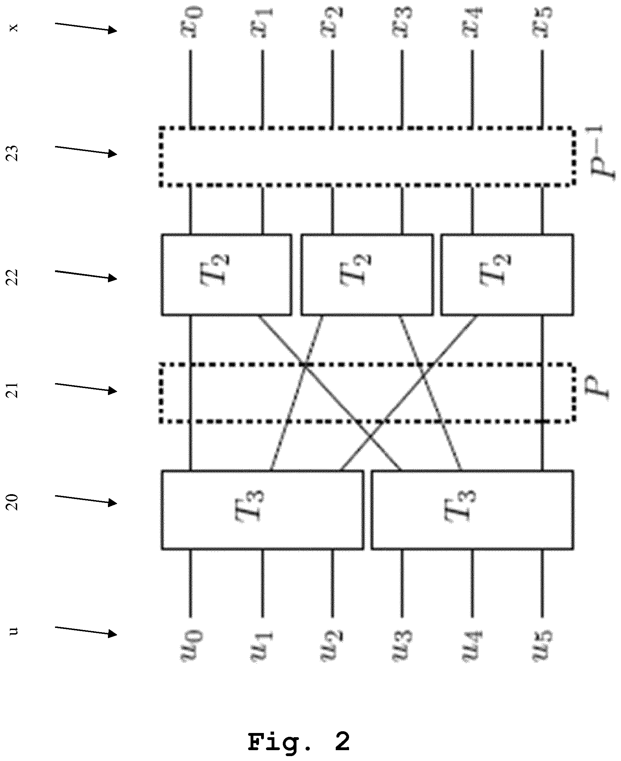

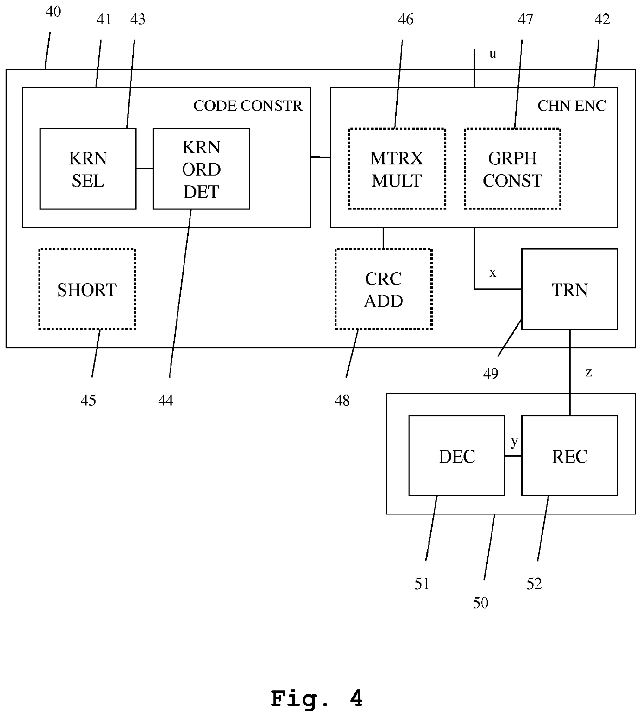

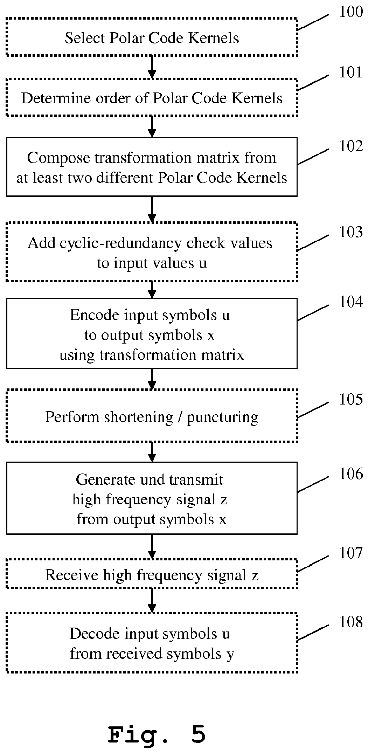

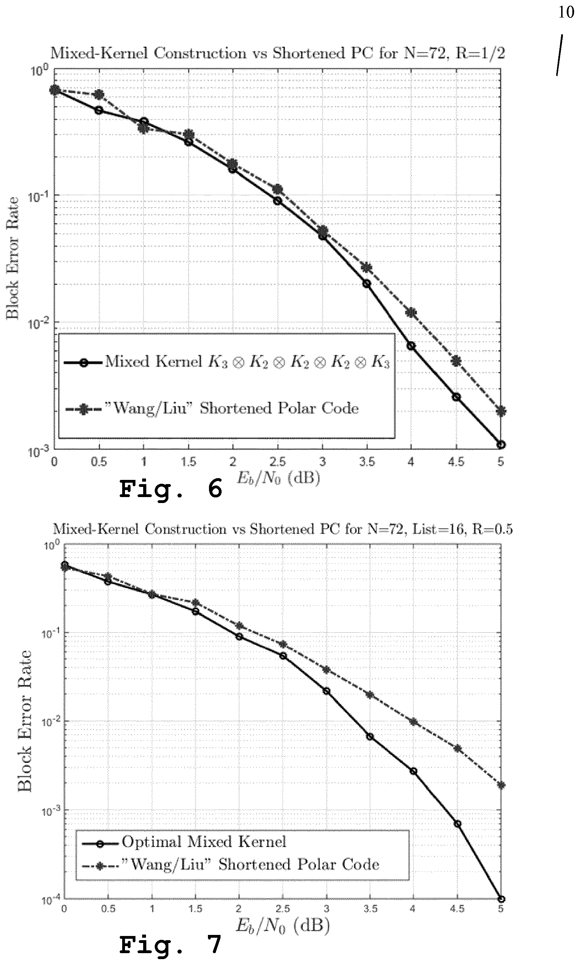

First we demonstrate the mathematics and the general concept of the present invention along Fig. 2 - 3. In a second step the function of an exemplary inventive device is shown with respect to Fig. 4. In Fig. 5, the function of an embodiment of the inventive method is shown. Finally, the benefits of the invention are shown with respect to Fig. 6 and 7. Similar entities and reference numbers in different figures have been partially omitted.

The present invention uses a generalized construction of polar codes based on a mixing of different Kernels in order to construct polar codes of various lengths. This allows a significant reduction of the complexity and a significant improvement of the error-rate performance of the resulting channel code as compared to punctured/shortened original polar codes with a $T_2$ Kernel.

In the remainder of this document we will denote by "binary Kernel" the $T_2$ Kernel while "q-ary Kernel" will denote the $T_q$ Kernel. Note that while we use q-ary Kernel as opposed to binary Kernel, all symbols considered throughout the document are binary (bits), i.e., 0s and 1s, such that the resulting polar codes are binary polar codes. The term "mixed" hence refers to the size of the Kernel component of the codes, and not to the alphabet of the code, which remains the Galois field of size 2.

We propose a mixed Kernel construction for polar codes. By using Kernels of different dimension in different layers, we show how to construct polar codes of block lengths that are not only powers of integers. This results in a mixed Kernel polar code with very good performance while the encoding complexity remains low and the decoding follows the same general structure as for usual binary Kernel codes.

The mixed-Kernel construction largely increases the number of possible code lengths that can be achieved without puncturing or shortening. By puncturing or shortening the newly constructed codes, any code length can be achieved. Using this polar code construction, only a very modest number of bits need to be punctured or shortened, if at all, and thus the loss in terms of complexity and performance is very small as compared to puncturing or shortening of the original polar codes. Similarly to the original polar codes, also the mixed-Kernel polar codes can be enhanced by a cyclic redundancy check (CRC), and this can be exploited in list decoding.

In one example, which will serve as an illustration of the principle of the present concept, we propose an implementation of the proposed solution for Kernels of dimension 2 and 3. In this case, any code with block length of the form $N = 2^{n_2} \cdot 3^{n_3}$ can be constructed without puncturing or shortening. We will observe the performance gains resulting from this code in comparison to state-of-the-art punctured polar codes.

Apart from using the present concept to obtain polar codes of lengths different than a power of two, the use of puncturing and shortening techniques have been suggested.

We can roughly divide the existing solutions in two categories:

1) Optimal frozen set: The optimal frozen set is found given a puncturing or shortening pattern. This technique is proposed for puncturing of non-systematic polar codes and for shortening of non-systematic polar codes. The shortening pattern is selected using the last bits of a (N,K) mother polar code. Similarly, the puncturing pattern is generated according to a certain heuristic, and a density evolution (DE) algorithm is run to find the optimal frozen set given the puncturing pattern and different puncturing or shortening patterns result in different frozen sets. In general, resulting frozen sets of different rates are not nested, so they need to be calculated for every individual encoding. Furthermore, DE is a complex algorithm, even if Gaussian approximation can be used to mitigate this issue. Even if the BLER performance of this technique is good, the latency augmentation due to DE calculation for every encoding makes this technique unattractive to use in systems where a low-latency is critical.

2) Optimal pattern: The optimal puncturing or shortening patterns are found given the frozen set of the mother polar code. This technique is used to create a punctured polar code. In particular, the less reliable bits are selected to be frozen, and an algorithm is run to find an optimal puncturing pattern leading to the selected frozen bits. The BLER of this technique is sub-optimal compared to other ones, but it is less complex to compute. However, the optimization algorithm has to be run every time a (N',K) polar code has to be generated, augmenting the latency of the system making the technique impossible to use in practical systems.

To summarize, the main shortcomings of the above-described techniques is the lack of structure of the frozen sets and puncturing or shortening patterns generated by these methods. In particular, every (N',K) code has a completely different frozen set and puncturing or shortening pattern that has to be stored or calculated on the fly. Hence these methods are not practical to implement due to their high latency and are not simple to describe in a systematic manner, such as tables of nested sets. Moreover, puncturing and shortening lead to a loss of performance compared to a full code.

In the following, it is shown how to construct polar codes using the proposed mixed-Kernel construction. In particular, the following is shown:

1) An encoding procedure
2) A decoding procedure
3) An embodiment for mixed binary and ternary Kernels.

According to the present concept, a mixed-Kernel construction of polar codes is proposed. Let us define $N$ the code length, such that $N = n_1 \cdot ... \cdot n_s$, with $n_i$ being prime numbers, not necessarily distinct. Note that every natural number can be decomposed in that way.

For the mixed-Kernel construction, the transformation matrix is given as $G_N = T_{n_1} \otimes ... \otimes T_{n_s}$, where $\otimes$ is the Kronecker product. Note that the ordering of the $T_{n_i}$ matrices in the Kronecker product matters, as the Kronecker operation is not commutative. This best ordering can be determined through the density evolution algorithm on the resulting transformation matrix and summing of the reliabilities of the K best bits, or similar methods. Finally, a codeword $x$ of length $N$ is obtained as $x = u \cdot G_N$, where the bits in u with positions in the frozen set are set to zero.

As for polar codes, the position of the information bits is decided according to the reliability of the bits, or according to other criteria, like code distance. The reliabilities can also be calculated using density evolution. Any code rate can be imposed, by storing the information in the K most reliable bits, and freezing the others, i.e., fixing them to the 0 value.

The encoding procedure of (N,K) mixed-Kernel polar codes can be formalized as follows:

1) Given $N = n_1 \cdot ... \cdot n_s$, select the Kernels $T_{n_1}, ..., T_{n_s}$.
2) Find the best permutation of Kernels $T_{n_1}, ..., T_{n_s}$, e.g. using density evolution, or choosing a random choice of ordering. The resulting transformation matrix is given by $G_N = T_{n_1} \otimes ... \otimes T_{n_s}$ where we assume that the Kernels in the Kronecker product are ordered.
3) Construct the overall permutation using the matrix $G_N$ (similar to the bit-reversal permutation for binary polar codes). We will give an example for the case $N = 6$.
4) Encode $x$ as $x = u \cdot G_N$. The encoding may be performed based on a Tanner graph or a matrix multiplication.

The decoding of mixed Kernel polar codes is done similarly to binary-Kernel polar codes using e.g. SC decoding on the Tanner graph of the code. However, assuming that $G_N = T_{n_1} \otimes ... \otimes T_{n_s}$, the LLRs would go through $N/n_1$ $T_{n_1}$-boxes of size $n_1$-by-$n_1$ on the first stage, etc., until going through $N/n_s$ $T_{n_s}$-boxes of size $n_s$-by-$n_s$ on the last stage. The generator matrix is given by $G_N = T_{n_1} \otimes ... \otimes T_{n_s}$, which means that the left-most stage in the decoding graph is constituted of Kernels $T_{n_s}$. We denote by s the numbers of Kernels used in $G_N$; e.g. if $G_N = T_2 \otimes T_3 \otimes T_5$, then $s = 3$.

The algorithmic description of this section will be clarified in the description of the mixed binary and ternary example. The update of the LLRs is then done according to update functions corresponding to the Kernel at a given stage. In the following embodiment, we describe the update functions of the LLRs for binary and ternary Kernels, these functions can be similarly obtained for other Kernel sizes.

The decoding procedure of mixed-Kernel polar codes is formalized as follows. First, we describe how to construct the encoding and decoding graph of the mixed-Kernel codes, similar to the one in Fig. 1. Later, we describe how to perform the successive cancellation decoding on this graph.

• Here we describe how to construct the graph given the transformation matrix $G_N = T_{n_1} \otimes ... \otimes T_{n_s}$. First, put the $T_n$-boxes similarly to the graph in Fig. 1, for binary-Kernel polar codes, where Stage 1, i.e., the rightmost stage in the graph, is constituted of $N/n_1$ $T_{n_1}$-boxes, until the last stage Stage s is constituted of $N/n_s$ $T_{n_s}$-boxes.
• Then, in order to construct the edges between Stage $i$ and Stage $i + 1$ we proceed as follows. We call $Q$-canonical permutation, the permutation transforming the vector $[1,...N]$ into the vector $[1, Q + 1, 2Q + 1...,2, Q + 2...N]$, e.g. for $[1,2,3,4,5,6]$ the 3-permutation is $[1,4,2,5,3,6]$. We also call $CP(i)$ the product $n_1 \cdot n_2 \cdot ... \cdot n_i$.

- We split the $N/n_i$ $T_{n_i}$ boxes and $N/n_{i+1}$ $T_{n_{i+1}}$ boxes into $N/CP(i + 1)$ blocks. For each of those $N/CP(i + 1)$ blocks, constituted of $Nn_i/CP(i + 1)$ bits we draw an edge bit $j$ of the Stage $i$ to its $n_{i+1}$-canonical permutation in Stage $i + 1$.

Graph construction example: In order to clarify this algorithmic description of the graph construction, let us construct the graph in Fig. 1, i.e. for the $G_8 = T_2 \otimes T_2 \otimes T_2$ Kernel using the algorithm. We first draw 3 stages, each constituted of $8/2 = 4$ $T_2$ boxes.

To construct the edges between Stage 1 and Stage 2, we calculate $CP(2) = 2 \cdot 2 = 4$. Hence we divide Stage 1 and Stage 2 into $N/CP(2) = 2$ Blocks, each constituted of 2 boxes or equivalently 4 bits. For each of the two blocks, the bits of Stage 1 are linked to their $n_2=2$-canonical permutation in Stage 2, i.e., $[1\ 2\ 3\ 4] \rightarrow [1\ 3\ 2\ 4]$. We observe indeed, in Figure 1, that bit 1 of stage 1 is connected to bit 1 of stage 2, bit 2 is connected to bit 3, etc. The same permutation occurs for the second blocks.

To construct the edges between Stage 2 and Stage 3, we calculate $CP(3)=2\cdot2\cdot2=8$. Hence we divide Stage 2 and Stage 3 into $N/CP(3) = 1$ Block, which is constituted of the 4 $T_2$ boxes or equivalently 8 bits. For each of the two blocks, the bits of Stage 2 are linked to their $n_3=2$-canonical permutation in Stage 3, i.e., $[1\ 2\ 3\ 4\ 5\ 6\ 7\ 8] \rightarrow [1\ 3\ 5\ 7\ 2\ 4\ 6\ 8]$, which is clear from the graph in Figure 1.

In the following, successive cancellation decoding is shown:

1) Calculate the LLRs of the codebits $x_i$ based on the received vector $y$.

2) Use SC decoding (alternatively list-SC and other variations) to decode bit-by-bit $u = [u_0, ..., u_i, ..., u_{N-1}]$ using LLR propagation through the graph. To decode $u_i$ we first check the nature of $u_i$ and $i$. if $u_i$ is a frozen bit, we decode it

as $\widehat{u_i} = 0$ and we move on to the next bit. If $u_i$ is an information bit, we check the value of $i\ mod(n_s)$.

- If $i \neq 0\ mod(n_s)$, this means that we can readily calculate $LLR(i, s)$, and hence decode $u_i$ by hard decision. Moreover, if $i = n_s - 1\ mod(n_s)$, we can propagate the hard values of previously decoded bits through the decoding graph, which is done according to the update functions.
- If $i = 0\ mod(n_s)$ we need to calculate $LLR(i, s)$ which is done using all the $LLR(j, s - 1)$, where the $j$'s are the $n_s$ indices such that $LLR(j, s - 1)$ are connected to the $T_{n_s}$ box of $u_i$ in the final stage. We then calculate the $n_s$ corresponding $LLR(j, s - 1)$ which are calculated according to the update rules corresponding to the $T_{n_{s-1}}$ Kernel, etc. These update rules are given later on for the case of binary and ternary Kernels, respectively.
- It is clear that using such a recursive procedure, the algorithm will arrive to the calculations of $LLR(\cdot,1)$ values in the graph, which are obtainable using the channel LLRs and the updating rules corresponding to $T_{n_1}$. Hence all the LLRs needed for the computation of $LLR(i, s)$ end up being calculated, and finally $LLR(i, s)$ is computed

and $\widehat{u_i}$ given by the hard decision corresponding to the sign of $LLR(i, s)$.

Similarly to the original polar codes, the new mixed-Kernel polar codes may be decoded with other decoding algorithms, including SC list decoding, CRC-aided list decoding, stack decoding, etc.

For better understanding, this general procedure for any Kernel size is now illustrated for the example of mixed binary and ternary Kernels. In particular we describe the updating rules for the binary Kernels, which are well-known as the canonical component of usual polar codes, and the updating rules for the ternary Kernels. Based on those two Kernels, we describe how to construct mixed binary and ternary Kernel polar codes, and how the SC decoding procedure provided earlier is applied to this construction.

Example: Mixed Binary and Ternary Polar Codes:

In order to clarify the general principle of the invention which were described above, we use the simple example of mixed binary and ternary polar codes, which allow us to construct polar codes for any length expressed as $N = 2^{n_2} \cdot 3^{n_3}$. In particular we use a canonical example of length 6 to illustrate the encoding and decoding.

First we give the update functions for fundamental blocks $T_2$ and $T_3$:

In the following, a summary of the decoding procedure and functions for $T_2$ boxes are shown:

Fundamental block

$$u_0, \lambda_0 \ \boxed{T_2} \ x_0, l_0$$
$$u_1, \lambda_1 \quad\quad x_1, l_1$$

Encoder inverse

$$u_0 = x_0 \oplus x_1$$
$$u_1 = u_0 \oplus x_0$$
$$= x_1$$

Message updates

Kernel

$$T_2 = \begin{pmatrix} 1 & 0 \\ 1 & 1 \end{pmatrix}$$

$$(u_0 \ u_1) \cdot T_2 = (x_0 \ x_1)$$

$$\lambda_0 = f_0(l_0, l_1)$$
$$= l_0 \boxplus l_1$$

$$\lambda_1 = f_1(\hat{u}_0, l_0, l_1)$$
$$= (-1)^{\hat{u}_0} \cdot l_0 + l_1$$

Encoder

$$u_0 \oplus u_1 = x_0$$
$$u_1 = x_1$$

Boxplus operator

$$a \boxplus b := 2 \tanh^{-1}\left(\tanh\frac{a}{2} \cdot \tanh\frac{a}{2}\right)$$

In the following, a summary of the decoding procedure and functions for $T_3$ boxes are shown:

Fundamental block

$$u_0, \lambda_0 \ \boxed{T_3} \ x_0, l_0$$
$$u_1, \lambda_1 \quad\quad x_1, l_1$$
$$u_2, \lambda_2 \quad\quad x_2, l_2$$

Encoder inverse

$$u_0 = x_0 \oplus x_1 \oplus x_2$$
$$u_1 = u_0 \oplus x_0$$
$$= x_1 \oplus x_2$$
$$u_2 = u_0 \oplus x_1$$
$$= u_0 \oplus u_1 \oplus x_2$$

Message updates

Kernel

$$T_3 = \begin{pmatrix} 1 & 1 & 1 \\ 1 & 0 & 1 \\ 0 & 1 & 1 \end{pmatrix}$$

$$(u_0 \ u_1 \ u_2) \cdot T_3 = (x_0 \ x_1 \ x_2)$$

Encoder

$$u_0 \oplus u_1 = x_0$$
$$u_0 \quad \oplus u_2 = x_1$$
$$u_0 \oplus u_1 \oplus u_2 = x_2$$

$$\lambda_0 = f_0(l_0, l_1, l_3)$$
$$= l_0 \boxplus l_1 \boxplus l_2$$

$$\lambda_1 = f_1(\hat{u}_0, l_0, l_1, l_2)$$
$$= (-1)^{\hat{u}_0} \cdot l_0 + l_1 \boxplus l_2$$

$$\lambda_2 = f_2(\hat{u}_0, \hat{u}_1, l_0, l_1, l_2)$$
$$= (-1)^{\hat{u}_0} \cdot l_1 + (-1)^{\hat{u}_0 \oplus \hat{u}_1} \cdot l_2$$

Let us illustrate the procedure described in the previous section for the example of a length 6 polar code, obtained from the $G_6 = T_2 \otimes T_3$ generator matrix. This polar code is illustrated in Fig. 2.

Encoding Procedure of Length-6 Polar Code $\underline{G_6 = T_2 \otimes T_3}$:

1) Let $u = [u_0, u_1, u_2, u_3, u_4, u_5]$ be the bits to be encoded, $K$ of which are information bits (according to the reliability order). The codeword $x = [x_0, x_1, x_2, x_3, x_4, x_5]$ is then constructed as $x = u \cdot G_6$, where $G_6 = T_2 \otimes T_3$. For instance from the first column of $G_6$ we have $x_0 = u_0 + u_1 + u_3 + u_4$, which is also observed in the graph of Fig. 2, combined with the definitions of the $T_2$ and $T_3$ boxes shown earlier.

2) Moreover, in a first stage 20, two $T_3$ boxes are located, while in the second stage 22, three $T_2$ boxes are located. The connection of the $T_2$ and $T_3$ boxes is according to the graph, explained earlier.

3) The graph of the encoder is stored, as well as an overall permutation of the code - for the binary Kernel polar codes this is the so-called bit-reversal permutation. From the graph of Fig. 2, we see that this permutation is $P = [0\ 2\ 4\ 1\ 3\ 5]$, by following the solid lines in the graph.

4) A permutation Box 21 defines the permutations of the symbols within the graph, while the inverse permutation box 23 actually performs a permutation so that the output symbols x can be arranged in the same order as the input symbols u.

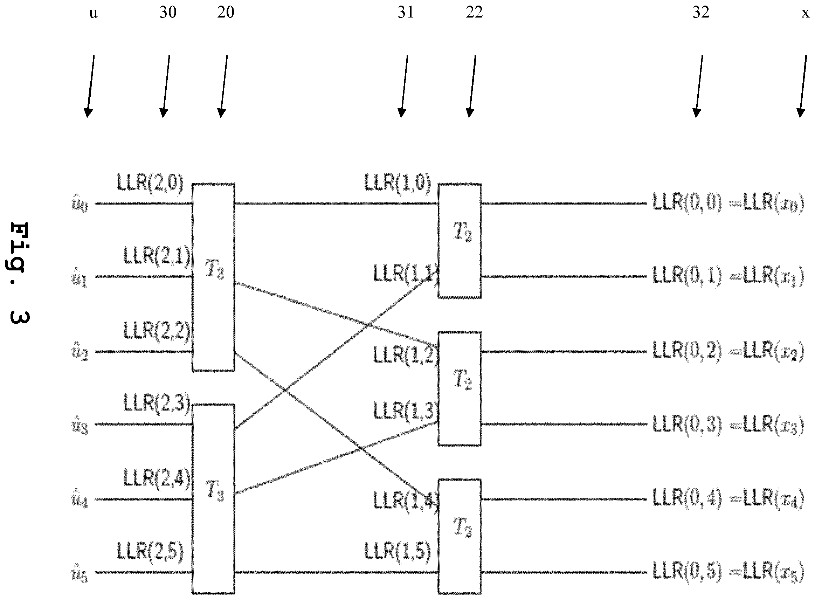

The decoding procedure of Length 6 Polar Code $G_6 = T_2 \otimes T_3$ is shown along Fig. 3.

We apply the generalized procedure of the Algorithm in the previous section for our $T_2 \otimes T_3$ code.

1) On the right side of the graph in Fig. 3 we have the channel LLRs 32 corresponding to $[x_0, ...,x_5]$.

2) We start by decoding $u_0$. If $u_0$ is a frozen bit, we set its value to 0 and move on to $u_1$. Otherwise, we check the Kernel size corresponding to the output LLR(2,0). Since it is a Kernel of size 3 and 0 (from $u_0$) is 0 modulo 3, we can decode $u_0$ if we have LLR(2,0). As we do not have LLR(2,0) out of a number of log likelihood ratios 30 of the first level, we need to compute it. Based on the graph of Fig. 3 and the previous description of the decoding of $T_2$ and $T_3$ boxes, we need to compute LLR(1,0), LLR(1,2), LLR(1,4) out of a number of log likelihood ratios 31 of the second level. Hence we move on to the second stage (the three $T_2$ boxes) to obtain these values, and we come back to LLR(2,0) once those are obtained. Next we obtain LLR(1,0) from LLR(0,0) and LLR(0,2) (see the description of the decoding of $T_2$ boxes earlier for details), and similarly LLR(1,2) and LLR(1,4) and we can go back to the decoding of $u_0$ by finally calculating LLR(2,0) and making a hard decision on $u_0$.

3) Then we decode $u_1$. Since 1 (of $u_1$) is 1 mod 3, we can readily obtain LLR(2,1) and decode $u_1$.

4) The same occurs for $u_2$. Finally since 2 is 2 mod 3 we can propagate the hard decisions through the graph, which will be useful in later stages. For instance at this stage we are able to propagate u(1,0)= $u_0$+$u_1$ at LLR(1,0), u(1,2)= $u_0$+$u_2$ at LLR(1,2) and u(1,4)= $u_0$+$u_1$+$u_2$ at LLR(1,4), according to the earlier provided decoding information regarding t3 blocks.

5) We then decode $u_3$, which follows the same procedure as $u_0$, since 3 is 0 modulo 3, etc.

In Fig. 4, an embodiment of the communication device 40 of the first aspect of the invention is shown. The communication device 40 comprises a code constructor 41 and a channel encoder 42. The code constructor comprises a Kernel selector 43 and a Kernel order determiner 44. Optionally, the communication device 40 additionally comprises a shortener 45.

The channel encoder 42 optionally comprises a matrix multiplier 46 and also optionally comprises a graph constructor 47. The communication device 40 moreover optionally comprises a cyclic redundancy check adder 48. Moreover, the communication device 40 comprises a transmitter 49.

Moreover, in Fig. 4, a further communication device 50 is depicted. The further communication device 50 comprises a receiver 52 and a decoder 51.

Both the communication device 40 and the further communication device 50 are only depicted as comprising the units and entities necessary for performing the function according to the first aspect of the invention. Naturally, the communication devices 40, 50 can comprise additional elements.

In order to perform a communication, the communication device 40 first of all determines a polar code by use of the code constructor 41. Based upon a code length N, the Kernel selector 43 selects at least two different polar code Kernels, which differ in their dimension. The Kernel selector 43 can also select more than two polar code Kernels in order to achieve an optimum match to the code length N. In case the code length N cannot be met by a multiplication of low prime numbers, the polar code Kernels can also be selected by the Kernel selector 43 so that the resulting code length N is insignificantly longer than the sought for code length. This is, for example, done if the selection of a code length of N would lead to the use of very high dimension polar code kernels due to performance limitations. The Kernel selector 43 determines if this is to be done and selects Kernels leading to a code length of greater than N. The Kernel selector 43 optionally also determined how a shortening or puncturing should be performed later on, in order to rectify the incorrect code length.

After the Kernel selector 43 has selected the pertinent polar code Kernels, the Kernel order determiner 44 determines, in which order the polar code Kernels are to be employed.

Both the determining of the selection of the polar code Kernels by the Kernel selector 43 as well as the Kernel order determining by the Kernel order determiner 44 can employ a code performance optimization or a density evolution analysis over at least some of the possibilities.

Once the polar code Kernels and their order have been determined, the resulting polar code is handed onto the channel encoder 42, which performs a channel encoding of a number of input symbols u using the polar code.

In one alternative construction, the channel encoder 42 comprises the matrix multiplier 46, which multiplies the input symbols u by the generator matrix determined by the code constructor 41.

In another alternative, the channel encoder 42 comprises the graph constructor 47, which constructs a Tanner graph from the generator matrix and encodes the input symbols u using the Tanner graph.

In case, a polar code of a code length larger than the desired code length N was selected, the shortener 45 can now perform the shortening or puncturing, in order to reach the desired code length on the output symbols x. In this case, the shortener 45 performs the shortening or the puncturing of resulting encoded output symbols x based on the information provided by the Kernel selector 43.

In a further optional construction, the communication device 40 comprises a cyclic redundancy check adder 48, which adds cyclic redundancy check symbols to the input symbols u before channel encoding by the channel encoder 42. These cyclic redundancy check symbols can later on be used to facilitate the decoding by the further communication device 50.

The encoded output symbols x, which have optionally undergone shortening or puncturing by the shortener 45, are handed to the transmitter 49, which generates a high frequency transmission signal z therefrom and transmits it to the further communication device.

The receiver 52 of the further communication device 50 receives the high frequency transmission signal z and determines a number of received symbols y therefrom. These are handed onto the decoder 51, which performs a decoding. For performing the decoding, a successive cancellation decoding or a list successive cancellation decoding or a cyclic-redundancy check-aided successive cancellation list decoding can be performed.

In Fig. 5, an embodiment of the communication method according to the second aspect of the invention is shown. In a first step 100 a number of polar code Kernels are selected. In a second step 101, an order of the polar code Kernels is determined. Both of these steps are optional steps. In a third step 102, a transformation matrix is composed from the at least two polar code Kernels. In fourth step 103, cyclic-redundancy check-values are added to input values u. In a fifth step 104, the input symbols u are encoded to output symbols x using the transformation matrix of the determined polar code. In a sixth step 105, a shortening or puncturing of the polar code is performed. Both the steps 103 and 105 are also optional steps. In seventh step 106, a high frequency signal z is generated based upon the output symbols x and transmitted. In an optional eighth step 107, the high frequency signal z is received. A number of received symbols y are detected. In a final optional ninth step 108, input symbols u are decoded from the received symbols y.

It is notable that the details of the function of the communication device 40, the further communication device 50 of Fig. 4 and of the method according to Fig. 5 are to be seen in context with each other and with the preliminary description of the function and the supporting mathematics.

For evaluating the performance, in particular we investigate the performance of the polar code of length $N = 72 = 2^3 \cdot 3^{22}$. For this length there exist 10 possible permutations of the Kernels $T_2$ and $T_3$, i.e., 10 different ways to construct the polar code. For K=36 information bits, density evolution analysis suggests us to use the code generated by the matrix $G_{72} = T_3 \otimes T_2 \otimes T_2 \otimes T_2 \otimes T_3$.

We compare the Block Error Rates (BLER) performance of the obtained code for an additive white Gaussian noise (AWGN) channel against a regular punctured polar code of length 72, obtained from a mother polar code of length 128.

In Fig. 6, the block error rate over a signal to noise ratio for an exemplary polar code of a code length N = 72 is shown. The dashed line shows a regular polar code with shortening, while the through line shows a mixed Kernel polar code according to the present invention. Here, a regular successive cancellation decoding has been performed. It can be seen that the regular shortened polar code is inferior in almost all values.

In Fig. 7, a comparable figure is shown, where a list successive cancellation decoding has been performed. Also here it can clearly be seen that the regular shortened polar code is disadvantageous.

The invention is not limited to the examples and especially not to wireless communication devices. It can especially also be employed in cable-based communications. Also a use in broadcast transmissions is possible. It is especially noteworthy, that Kernel dimensions of the individual polar code Kernels can be any prime number. According to the invention, at least one Polar Code Kernel of a dimension of 2 and of at least one Polar Code Kernel of a dimension of 3 are used.

The invention has been described in conjunction with various embodiments herein. However, other variations to the disclosed embodiments can be understood and effected by those skilled in the art in practicing the claimed invention, from a study of the drawings, the disclosure and the appended claims. In the claims, the word "comprising" does not exclude other elements or steps and the indefinite article "a" or "an" does not exclude a plurality. A single processor or other unit may fulfill the functions of several items recited in the claims. The mere fact that certain measures are recited in usually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the internet or other wired or wireless communication systems.

**Claims**

1. A communication device (40), comprising a code constructor (41) and a channel encoder (42),

wherein the channel encoder (42) is configured to encode a number of input symbols u to a number of output symbols x using a Polar Code of a code length N with a transformation matrix $G_N$,

wherein the code constructor (41) is configured to compose the transformation matrix $G_N$ from at least two different Polar Code Kernels,

wherein the code constructor (41) is configured to compose the transformation matrix $G_N$ from at least one Polar Code Kernel of a dimension of 2 and of at least one Polar Code Kernel of a dimension of 3,

wherein the code constructor (41) is configured to compose the transformation matrix $G_N$ by performing a Kronecker product of the Polar Code Kernels,

wherein code constructor (41) comprises a Kernel order determiner (44), configured to determine an order of performing the Kronecker product of the Polar Code Kernels by optimizing a code performance or by performing a density evolution analysis over at least some of all possible permutations of the Polar Code Kernels.

2. The communication device (40) of claim 1,
wherein code constructor (41) comprises a Kernel selector (43), configured to determine the at least two different Polar Code Kernels based on the code length N,

   - so that a product of the Polar Code Kernel dimensions of all employed Polar Code Kernels is N, or
   - so that a product of the Polar Code Kernel dimensions of all employed Polar Code Kernels is greater than N, wherein the communication device (40) then furthermore comprises a shortener (45), configured to perform a shortening or a puncturing of the Polar Code to a code length N.

3. The communication device (40) of claim 2,
wherein the Kernel selector (43) is configured to select the at least two different Polar Code Kernels by optimizing a code performance or by performing a density evolution analysis over at least some of all possible Polar Code Kernels and/or over at least some of all possible frozen sets.

4. The communication device (40) of any of the claims 1 to 3,
wherein the channel encoder (42) comprises a matrix multiplier (46), configured to encode the number of input symbols u to the number of output symbols x, by multiplying the input symbols u with the transformation matrix $G_N$.

5. The communication device (40) of any of the claims 1 to 3,

   wherein the channel encoder (42) comprises a graph constructor (47), configured to construct an encoding graph based upon the Polar Code, and
   wherein the channel encoder (42) is configured to encode the number of input symbols u to the number of output symbols x, using the encoding graph.

6. The communication device (40) of any of the claims 1 to 5,
wherein the communication device (40) comprises a cyclic-redundancy check adder (48), configured to add cyclic-redundancy check symbols to the number of input symbols u before the channel encoder (42) performs the encoding.

7. The communication device (40) of any of the claims 1 to 6,
wherein the communication device (40) comprises a transmitter (49), configured to

   - generate a high frequency transmission signal z from the number of output symbols x, and
   - transmit the high frequency transmission signal z.

8. A communication system comprising a communication device (40) according to claim 7, and a further communication device (50),
wherein the further communication device (50) comprises

   - a receiver (52), configured to receive the high frequency transmission signal and determine a number of received symbols y corresponding to the number of output symbols x, and
   - a decoder (51), configured to decode the number of received symbols y.

9. The communication system according to claim 8,
wherein the decoder (51) is configured to decode the number of received symbols y, using successive cancellation decoding or list successive cancellation decoding or cyclic-redundancy check-aided successive cancellation list decoding.

**10.** A communication method in a communication device, comprising the steps of:

- composing (102) a transformation matrix $G_N$ from at least two different Polar Code Kernels, and
- encoding (105) a number of input symbols u to a number of output symbols x using a Polar Code of a code length N with the transformation matrix $G_N$;

wherein composing the transformation matrix $G_N$ is from at least one Polar Code Kernel of a dimension of 2 and of at least one Polar Code Kernel of a dimension of 3,

wherin composing the transformation matrix $G_N$ by performing a Kronecker product of the Polar Code Kernels, wherein composing the transformation matrix $G_N$ includes determining an order of performing the Kronecker product of the Polar Code Kerne by optimizing a code performance or by performing a density evolution analysis over at least some of all possible permutations of the Polar Code Kernels.

**11.** A computer program with a program code which, when the program is executed by a computer, causes the computer to perform the method according to claim 10.


**Patentansprüche**

**1.** Kommunikationsvorrichtung (40), die einen Code-Konstruktor (41) und einen Kanal-Codierer (42) umfasst,

wobei der Kanal-Codierer (42) konfiguriert ist, um eine Anzahl von Eingangssymbolen u in eine Anzahl von Ausgangssymbolen x zu codieren, indem ein Polar-Code einer Codelänge N mit einer Transformationsmatrix $G_N$ verwendet wird, wobei der Code-Konstruktor (41) konfiguriert ist, um die Transformationsmatrix $G_N$ aus mindestens zwei verschiedenen Polar-Code-Kernels zusammenzusetzen,
wobei der Code-Konstruktor (41) konfiguriert ist, um die Transformationsmatrix $G_N$ aus mindestens einem Polar-Code-Kernel mit einer Dimension von 2 und mindestens einem Polar-Code-Kernel mit einer Dimension von 3 zusammenzusetzen,
wobei der Code-Konstruktor (41) konfiguriert ist, um die Transformationsmatrix $G_N$ zusammenzusetzen, indem ein Kronecker-Produkt der Polar-Code-Kernels ausgeführt wird,
wobei der Code-Konstruktor (41) eine Einheit zum Bestimmen einer Ordnung eines Kernels (44) umfasst, die konfiguriert ist, um eine Ordnung zum Ausführen des Kronecker-Produkts der Polar-Code-Kernels zu bestimmen, indem eine Code-Leistungsfähigkeit optimiert wird, oder indem eine Dichteevolutionsanalyse über mindestens einige von allen möglichen Permutationen des Polar-Code-Kernels ausgeführt wird.

**2.** Kommunikationsvorrichtung (40) nach Anspruch 1,
wobei der Code-Konstruktor (41) eine Kernel-Auswahleinheit (43) umfasst, die konfiguriert ist, um die mindestens zwei verschiedenen Polar-Code-Kernels aufgrund der Codelänge N zu bestimmen,

- sodass ein Produkt der Polar-Code-Kernel-Dimensionen aller eingesetzten Polar-Code-Kernels gleich N ist, oder
- sodass ein Produkt der Polar-Code-Kernel-Dimensionen aller eingesetzten Polar-Code-Kernels größer als N ist, wobei die Kommunikationsvorrichtung (40) dann außerdem einen Verkürzer (45) umfasst, der konfiguriert ist zum Ausführen eines Verkürzens oder eines Punktierens des Polar-Codes auf eine Codelänge N.

**3.** Kommunikationsvorrichtung (40) nach Anspruch 2,
wobei die Kernel-Auswahleinheit (43) konfiguriert ist, um die mindestens zwei verschiedenen Polar-Code-Kernels auszuwählen, indem eine Code-Leistungsfähigkeit optimiert wird, oder indem eine Dichteevolutionsanalyse über mindestens einige von allen möglichen Polar-Code-Kernels und/oder über mindestens einige von allen möglichen eingefrorenen Gruppen ausgeführt wird.

**4.** Kommunikationsvorrichtung (40) nach einem der Ansprüche 1 bis 3,
wobei der Kanal-Codierer (42) einen Matrixmultiplizierer (46) umfasst, der konfiguriert ist, um die Anzahl von Eingangssymbolen u in die Anzahl von Ausgangssymbolen x zu codieren, indem die Eingangssymbole u mit der Transformationsmatrix $G_N$ multipliziert werden.

**5.** Kommunikationsvorrichtung (40) nach einem der Ansprüche 1 bis 3,

wobei der Kanal-Codierer (42) einen Grafik-Konstruktor (47) umfasst, der konfiguriert ist, um eine Codierungsgrafik aufgrund des Polar-Codes zu konstruieren, und
wobei der Kanal-Codierer (42) konfiguriert ist, um die Anzahl von Eingangssymbolen u mithilfe der Codierungsgrafik in die Anzahl von Ausgangssymbolen x zu codieren.

**6.** Kommunikationsvorrichtung (40) nach einem der Ansprüche 1 bis 5,
wobei die Kommunikationsvorrichtung (40) eine zyklische Redundanzprüfungsergänzungseinheit (48) umfasst, die konfiguriert ist, um Symbole einer zyklischen Redundanzprüfung zu der Anzahl von Eingangssymbolen u hinzuzufügen, bevor der Kanal-Codierer (42) das Codieren ausführt.

**7.** Kommunikationsvorrichtung (40) nach einem der Ansprüche 1 bis 6,
wobei die Kommunikationsvorrichtung (40) außerdem einen Sender (49) umfasst, der konfiguriert ist zum:

- Erzeugen eines Hochfrequenzsendesignals z aus der Anzahl von Ausgangssymbolen x, und
- Senden des Hochfrequenzsendesignals z.

**8.** Kommunikationssystem, das eine Kommunikationseinrichtung (40) nach Anspruch 7 und eine weitere Kommunikationseinrichtung (50) umfasst,
wobei die weitere Kommunikationsvorrichtung (50) umfasst:

- einen Empfänger (52), der konfiguriert ist, um das Hochfrequenzsendesignal zu empfangen und um eine Anzahl von empfangenen Symbolen y zu ermitteln, die der Anzahl von Ausgangssymbolen x entspricht, und
- einen Decodierer (51), der konfiguriert ist, um die Anzahl von empfangenen Symbolen y zu decodieren.

**9.** Kommunikationssystem nach Anspruch 8, wobei der Decodierer (51) konfiguriert ist, um die Anzahl von empfangenen Symbolen y mithilfe einer "Successive-Cancellation"-Decodierung oder einer "Successive-Cancellation"-Listendecodierung oder einer durch eine zyklische Redundanzprüfung unterstützte "Successive-Cancellation"-Listendecodierung zu decodieren.

**10.** Kommunikationsverfahren in einer Kommunikationsvorrichtung, das die folgenden Schritte umfasst:

- Zusammensetzen (102) einer Transformationsmatrix $G_N$ aus mindestens zwei verschiedenen Polar-Code-Kernels, und
- Codieren (105) einer Anzahl von Eingangssymbolen u in eine Anzahl von Ausgangssymbolen x mithilfe eines Polar-Codes einer Codelänge N mit der Transformationsmatrix $G_N$;

wobei das Zusammensetzen der Transformationsmatrix $G_N$ aus mindestens einem Polar-Code-Kernel mit einer Dimension von 2 und mindestens einem Polar-Code-Kernel mit einer Dimension von 3 erfolgt,

wobei das Zusammensetzen der Transformationsmatrix $G_N$ erfolgt, indem ein Kronecker-Produkt der Polar-Code-Kernels ausgeführt wird,
wobei das Zusammensetzen der Transformationsmatrix $G_N$ ein Bestimmen einer Ordnung des Ausführens des Kronecker-Produkts der Polar-Code-Kernels beinhaltet, indem eine Code-Leistungsfähigkeit optimiert wird, oder indem eine Dichteevolutionsanalyse über mindestens einige von allen möglichen Permutationen des Polar-Code-Kernels ausgeführt wird.

**11.** Computerprogramm mit einem Programmcode, der, wenn das Programm durch einen Computer ausgeführt wird, den Computer veranlasst, das Verfahren nach Anspruch 10 auszuführen.

**Revendications**

**1.** Dispositif de communication (40), comprenant un constructeur de code (41) et un codeur de canal (42),

dans lequel le codeur de canal (42) est conçu pour coder un nombre de symboles d'entrée u en un nombre de symboles de sortie x en utilisant un code polaire d'une longueur de code N avec une matrice de transformation $G_N$,

dans lequel le constructeur de code (41) est conçu pour composer la matrice de transformation $G_N$ à partir d'au moins deux noyaux de codes polaires différents,

dans lequel le constructeur de code (41) est conçu pour composer la matrice de transformation $G_N$ à partir d'au moins un noyau de code polaire d'une dimension de 2 et d'au moins un noyau de code polaire d'une dimension de 3,

dans lequel le constructeur de code (41) est conçu pour composer la matrice de transformation $G_N$ en exécutant un produit de Kronecker des noyaux de codes polaires,

dans lequel le constructeur de code (41) comprend un dispositif de détermination d'ordre de noyau (44), conçu pour déterminer un ordre d'exécution du produit de Kronecker des noyaux de codes polaires en optimisant une performance de code ou en exécutant une analyse d'évolution de densité sur au moins certaines de toutes les permutations possibles des noyaux de codes polaires.

2. Dispositif de communication (40) selon la revendication 1,

dans lequel le constructeur de code (41) comprend un sélectionneur de noyau (43), conçu pour déterminer les au moins deux noyaux de codes polaires différents sur la base de la longueur de code N,

- de sorte qu'un produit des dimensions de noyaux de codes polaires de tous les noyaux de codes polaires utilisés est N, ou
- de sorte qu'un produit des dimensions de noyaux de codes polaires de tous les noyaux de codes polaires utilisés est supérieur à N, le dispositif de communication (40) comprenant alors en outre un dispositif de raccourcissement (45), conçu pour effectuer un raccourcissement ou une perforation du code polaire à une longueur de code N.

3. Dispositif de communication (40) selon la revendication 2,

dans lequel le sélectionneur de noyau (43) est conçu pour sélectionner les au moins deux noyaux de codes polaires différents, en optimisant une performance de code ou en exécutant une analyse d'évolution de densité sur au moins certains de tous les noyaux de codes polaires possibles et/ou sur au moins certains de tous les ensembles gelés possibles.

4. Dispositif de communication (40) selon l'une quelconque des revendications 1 à 3, dans lequel le codeur de canal (42) comprend un multiplicateur de matrice (46), conçu pour coder le nombre de symboles d'entrée u en le nombre de symboles de sortie x, en multipliant les symboles d'entrée u par la matrice de transformation $G_N$.

5. Dispositif de communication (40) selon l'une quelconque des revendications 1 à 3,

dans lequel le codeur de canal (42) comprend un constructeur graphique (47), conçu pour construire un graphique de codage sur la base du code polaire, et
dans lequel le codeur de canal (42) est conçu pour coder le nombre de symboles d'entrée u en le nombre de symboles de sortie x, en utilisant le graphique de codage.

6. Dispositif de communication (40) selon l'une quelconque des revendications 1 à 5,

le dispositif de communication (40) comprenant un additionneur de contrôle à redondance cyclique (48), conçu pour ajouter des symboles de contrôle à redondance cyclique au nombre de symboles d'entrée u avant que le codeur de canal (42) n'effectue le codage.

7. Dispositif de communication (40) selon l'une quelconque des revendications 1 à 6,

le dispositif de communication (40) comprenant un émetteur (49), conçu pour :

- générer un signal de transmission haute fréquence z à partir du nombre de symboles de sortie x, et
- transmettre le signal de transmission haute fréquence z.

8. Système de communication comprenant un dispositif de communication (40) selon la revendication 7, et un dispositif de communication supplémentaire (50),

dans lequel le dispositif de communication supplémentaire (50) comprend :

- un récepteur (52), conçu pour recevoir un signal de transmission haute fréquence et déterminer un nombre de symboles reçus y correspondant au nombre de symboles de sortie x, et
- un décodeur (51), conçu pour décoder le nombre de symboles reçus y.

**9.** Système de communication selon la revendication 8,
dans lequel le décodeur (51) est conçu pour décoder le nombre de symboles reçus y, à l'aide d'un décodage d'annulation successif ou d'un décodage d'annulation successif de liste ou d'un décodage de liste d'annulation successif assisté par contrôle à redondance cyclique.

**10.** Procédé de communication dans un dispositif de communication, comprenant les étapes consistant à :

- composer (102) une matrice de transformation $G_N$ à partir d'au moins deux noyaux de codes polaires différents, et
- coder (105) un nombre de symboles d'entrée u en un nombre de symboles de sortie x en utilisant un code polaire d'une longueur de code N avec la matrice de transformation $G_N$ ;

dans lequel composer la matrice de transformation $G_N$ vient d'au moins un noyau de code polaire d'une dimension de 2 et d'au moins un noyau de code polaire d'une dimension de 3,

dans lequel composer la matrice de transformation $G_N$ est effectué en exécutant un produit de Kronecker des noyaux de codes polaires,
dans lequel composer la matrice de transformation $G_N$ inclut la détermination d'un ordre d'exécution du produit de Kronecker des noyaux de codes polaires en optimisant une performance de code ou en exécutant une analyse d'évolution de densité sur au moins certaines de toutes les permutations possibles des noyaux de codes polaires.

**11.** Programme informatique ayant un code de programme qui, lorsque le programme est exécuté par un ordinateur, amène l'ordinateur à mettre en œuvre le procédé selon la revendication 10.

Fig. 1

Fig. 2

Fig. 3

**Fig. 4**

Select Polar Code Kernels — 100

Determine order of Polar Code Kernels — 101

Compose transformation matrix from at least two different Polar Code Kernels — 102

Add cyclic-redundancy check values to input values u — 103

Encode input symbols u to output symbols x using transformation matrix — 104

Perform shortening / puncturing — 105

Generate und transmit high frequency signal z from output symbols x — 106

Receive high frequency signal z — 107

Decode input symbols u from received symbols y — 108

# Fig. 5

Mixed-Kernel Construction vs Shortened PC for N=72, R=1/2

**Fig. 6**

Mixed-Kernel Construction vs Shortened PC for N=72, List=16, R=0.5

**Fig. 7**

**REFERENCES CITED IN THE DESCRIPTION**

**Non-patent literature cited in the description**

- **MAHDAVIFAR HESSAM et al.** Polar Coding for Bit-Interleaved Coded Modulation. *IEEE Transactions on Vehicular Technology,* vol. 65 (5
- **TRIFONOV PETER et al.** Fast Encoding of Polar Codes With Reed-Solomon Kernel. *IEEE Transactions on Communications,* July 2016, vol. 64 (7
- **HUAWEI.** Overview of Polar Codes. *3GPP draft; R1-162161, RAN WG1, Busan, Korea*
- **MYUNG-KYU LEE et al.** The Exponent of a Polarizing Matrix Constructed from the Kronecker Product. *ARXIV.ORG,* August 2011